**Europäisches Patentamt**

**European Patent Office**

**Office européen des brevets**

(19)

(11) Veröffentlichungsnummer: **0 162 278**
**B1**

(12) # EUROPÄISCHE PATENTSCHRIFT

(45) Veröffentlichungstag der Patentschrift:
23.08.89

(51) Int. Cl.⁴: **H 03 C 1/62**

(21) Anmeldenummer: **85104556.7**

(22) Anmeldetag: **15.04.85**

(54) Verfahren zur Trägersteuerung eines amplitudenmodulierten Senders und Schaltungsanordnung zur Durchführung des Verfahrens.

(30) Priorität: **10.05.84 CH 2303/84**

(43) Veröffentlichungstag der Anmeldung:
**27.11.85 Patentblatt 85/48**

(45) Bekanntmachung des Hinweises auf die Patenterteilung:
**23.08.89 Patentblatt 89/34**

(84) Benannte Vertragsstaaten:
**CH DE FR GB LI NL**

(56) Entgegenhaltungen:
**CH-A-634 183**
**DE-A-3 044 956**
**FR-A-2 445 664**
**GB-A-2 015 283**
**US-A-4 412 337**

(73) Patentinhaber: **BBC Brown Boveri AG,
Haselstrasse, CH- 5401 Baden (CH)**

(72) Erfinder: **Furrer, Andreas, Im Feld 5, CH- 5237
Mönthal (CH)**

EP 0 162 278 B1

## Beschreibung

Die vorliegende Erfindung geht aus von einem Verfahren zur Trägersteuerung eines amplitudenmodulierten Senders gemäss dem Oberbegriff des Anspruchs 1. Ein solches Verfahren ist aus der CH-A-634 183 bekannt.

Bei dem bekannten Verfahren wird das am Eingang des Senders anstehende und über den Sender zu übertragende, niederfrequente Nutzsignal einerseits in eine Folge von pulsdauermodulierten Impulsen umgewandelt, mit denen ein Schaltverstärker leitend und nicht leitend gesteuert wird. Andererseits wird ein Teil des ankommenden Nutzsignals abgezweigt und gleichgerichtet. In einer Siebkette werden dann die hörbaren Wechselströme weggesiebt. Es bleibt hinter der Siebkette eine langsam veränderliche Gleichspannung, die dem Dynamikverlauf des Nutzsignals entspricht. Diese langsam veränderliche Gleichspannung wird dem Nutzsignal vor der Umwandlung in pulsdauermodulierte Impulse überlagert.

Bei der nachfolgenden Pulsdauermodulation, die nach dem bekannten Sägezahnverfahren arbeitet, führt die Überlagerung der langsam veränderlichen Gleichspannung zu einer dynamikabhängigen Verschiebung des Arbeitspunktes, die sich am Ausgang des Schaltverstärkers als dynamikabhängiger Gleichspannungsanteil bemerkbar macht. Dieser Gleichspannungsanteil beeinflusst bei der nachfolgenden Modulation der Trägerschwingung seinerseits den Arbeitspunkt auf der Modulationskennlinie, so dass eine direkte dynamikabhängige Trägersteuerung erfolgt.

Das beschriebene Verfahren der Trägersteuerung nach dem Stand der Technik stützt sich auf die Erzeugung einer analogen, dynamikabhängigen Gleichspannung durch Gleichrichtung und anschliessende Siebung des Nutzsignals. Insbesondere diese Siebung, d.h. die zeitliche Mittelung über die veränderliche Nutzsignalamplitude, hat gravierende Einschränkungen für die Reaktionsschnelligkeit des Trägersteuerungssystems bei impulsförmigen Änderungen dieser Nutzsignalamplitude (sog. "Ton-bursts") zur Folge. Die Trägeramplitude kann solchen impulsförmigen Änderungen nur in dem bescheidenen Rahmen nachfolgen, der durch die grosse Zeitkonstante der Siebkette vorgegeben ist.

Diese Trägheit der bekannten Trägersteuerung führt zu nicht vernachlässigbaren Verzerrungen bei der Übertragung des Nutzsignals zum Empfänger, so dass eine deutliche Einbusse in der Übertragungsqualität zu verzeichnen ist.

Es ist weiterhin bekannt (US-A-4 412 337 und FR-A-2 445 664), zur Korrektur von Signalformen, die durch nichtlineare Verstärkung verzerrt werden, digitale Rechenschaltungen vorzusehen, die aus einem Vergleich des verstärkten Signals mit einem Sollsignal eine Korrekturgrösse errechnen, mit der das Signal vor der Verstärkung beaufschlagt wird. Eine Trägersteuerung findet bei diesen bekannten Verfahren jedoch nicht statt.

Aufgabe der vorliegenden Erfindung ist es daher, ein Verfahren und eine Schaltungsanordnung zur Trägersteuerung eines amplitudenmodulierten Senders zu schaffen, wobei eine weitgehend verzögerungsfreie Anpassung der Trägeramplitude auch bei schnellen Änderungen der Nutzsignalamplitude ermöglicht wird und damit eine Verbesserung in der Übertragungsqualität erreicht wird.

Die Aufgabe wird für ein Verfahren durch die Merkmale des Anspruchs 1 gelöst.

Die erfindungsgemässe, vollständig digitalisierte Trägersteuerung, die auch die Verstärkung des dynamikabhängigen, digitalen Steuersignalwerts in einem digitalen Schaltverstärker einschliesst, zeichnet sich aus durch eine minimale, schaltungsbedingte Verzögerung bei der Erzeugung des digitalen Trägersteuerungswertes, die von der Grössenordnung der Zykluszeit ist, welche bei der Analog-Digital-Wandlung und der Berechnung des Trägersteuerungswerts auftritt und typischerweise im Mikrosekunden-Bereich liegt.

Besondere Vorteile ergeben sich durch die digitale Signalverarbeitung im erfindungsgemässen Trägersteuerungsverfahren hinsichtlich der Anpassungsfähigkeit an unterschiedliche, im Sendebetrieb auftretende Anforderungen. Die der Berechnung des Trägersteuerungswerts zugrundeliegende Trägersteuerungskennlinien lässt sich in einfacher Weise durch geeignete Programmierungsschritte verändern und damit im Sinne der Energieersparnis schnell und optimal an den jeweiligen Sendebetrieb anpassen. Darüberhinaus können auch andere Parameter der Trägersteuerung, wie z. B. eine verzögerte Absenkung der Trägeramplitude in Programmpausen, auf der Programmierungsebene beeinflusst werden, ohne den schaltungsmässigen Aufbau der Trägersteuerung zu verändern.

Bei dem bevorzugten Ausführungsbeispiel gemäss Anspruch 2 ergibt sich aus der Abspeicherung der Trägerabsenkungswerte, dem Vergleich zwischen Trägerkennlinienwert und Speicherinhalt und der speziellen Änderung des Speicherinhalts in Abhängigkeit von dem Ergebnis des genannten Vergleichs ein besonders vorteilhaftes Zeitverhalten der Trägersteuerung: Bei impulsartigem Anstieg der Nutzsignalamplitude wird die Trägeramplitude gemäss der Trägersteuerungskennlinie nahezu verzögerungsfrei aufwärtsgesteuert, während bei einem längeranhaltenden Abfallen der Nutzsignalamplitude der Trägerpegel zunächst für eine feste Verzögerungszeit auf höherem Niveau konstant gehalten und erst nach Ablauf der Verzögerungszeit schrittweise abgesenkt wird, sofern nicht ein zwischenzeitlicher Tonburst eine neue Anhebung des Pegels erforderlich werden lässt.

Diese unterschiedliche Zeitverhalten bei Anstieg und Abfall der Nutzsignalamplitude kombiniert in besonders günstiger Weise hohe Einsparungen bei der Trägerleistung mit sehr geringen Dynamikverzerrungen bei der Nutzsignalübertragung.

Die Schaltungsanordnung zur Durchführung des erfindungsgemässen Trägersteuerverfahrens nach Anspruch 7 enthält zwischen dem eingangsseitigen Analog-Digital-Wandler und dem ausgangsseitigen digitalen Schaltverstärker im wesentlichen eine Subtraktionsschaltung, die von einem Eingangswert, der einem konstanten Trägerpegel entspricht, einen in der digitalen Rechenschaltung berechneten dynamikabhängigen Digitalwert abzieht und am Ausgang einen dynamikabhängigen digitalen Steuersignalwert zur Ansteuerung des Schaltverstärkers bereitstellt.

Nachfolgend soll nun die Erfindung anhand der Zeichnung in Ausführungsbeispielen näher erläutert werden. Es zeigen:

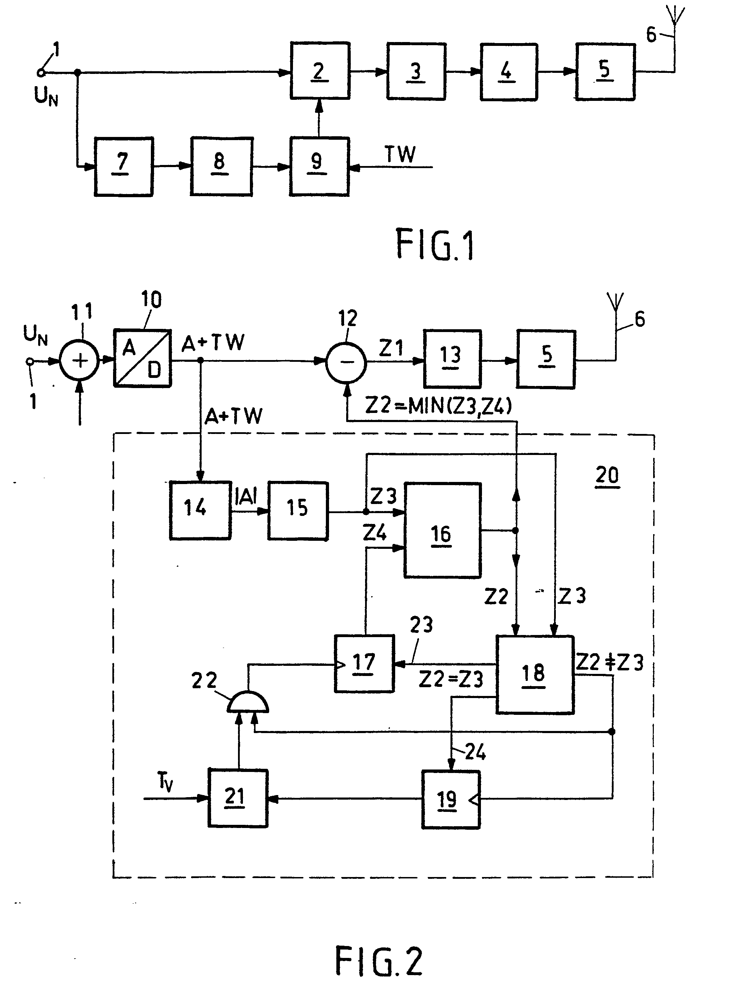

Fig. 1     das Blockschaltbild einer analogen Trägersteuerung nach dem Stand der Technik;

Fig. 2
           das Blockschaltbild einer Schaltungsanordnung zur Durchführung des erfindungsgemässen Trägersteuerungsverfahrens;

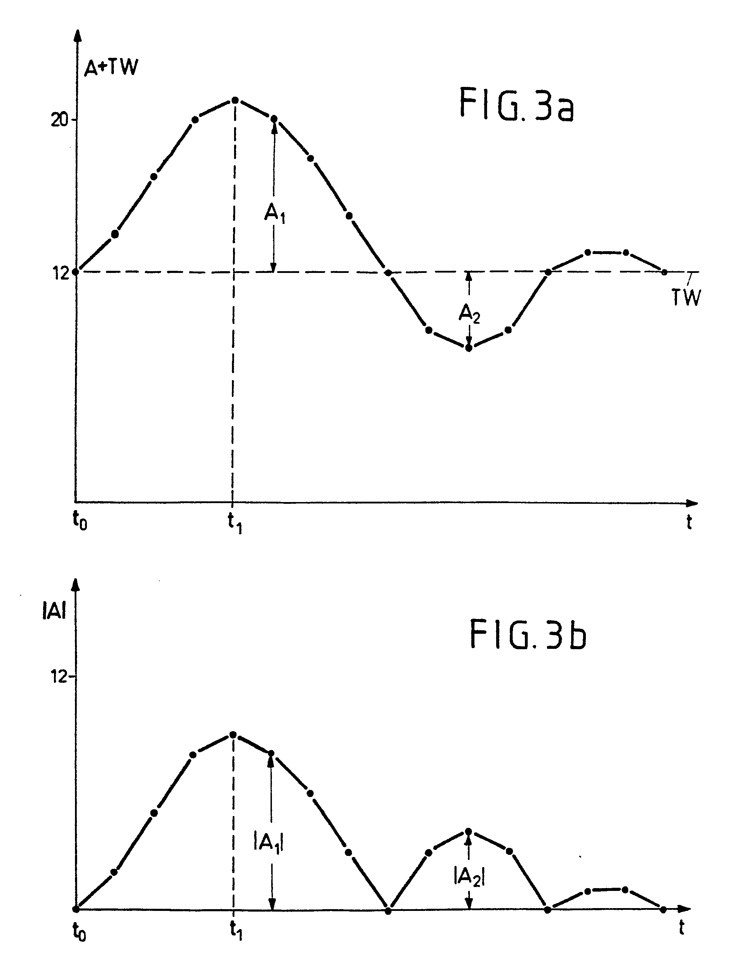

Fig. 3a    beispielhafte Diagramme der in einer
- g        Schaltungsanordnung gem. Fig. 2 auftretenden digitalen Grössen; insbesondere:

Fig. 3a    den zeitlichen Verlauf einer beispielhaften, digitalisierten Nutzsignalamplitude mit einem überlagerten Trägerwert;

Fig. 3b    den zeitlichen Verlauf des dem Absolutbetrag entsprechenden digitalen Amplitudenwerts;

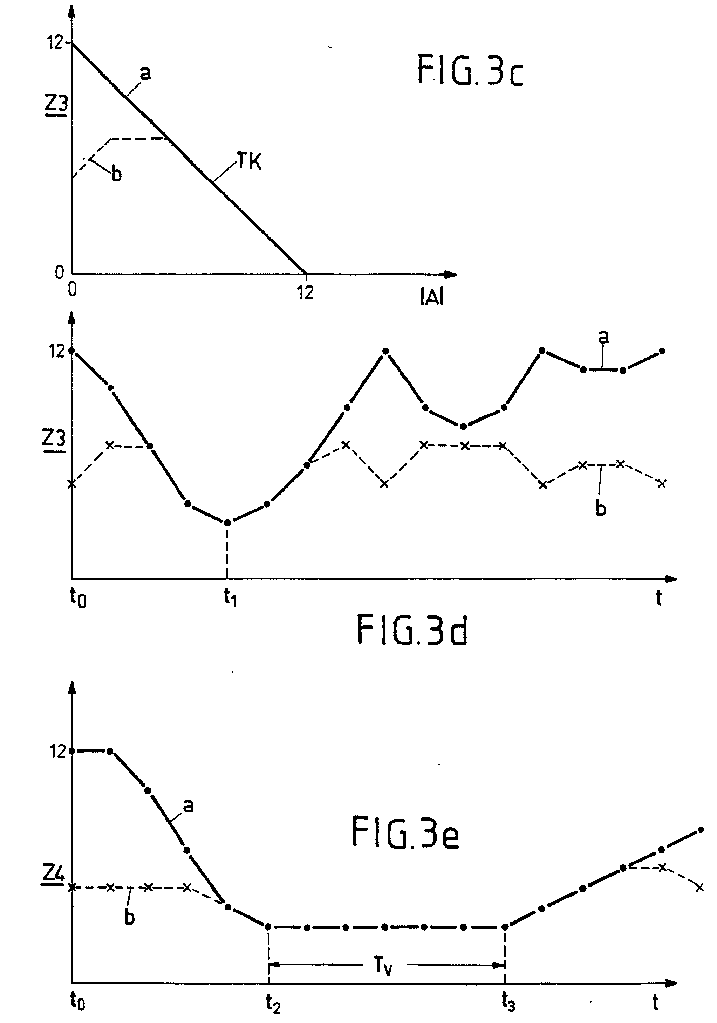

Fig. 3c    zwei mögliche Trägersteuerungskennlinien;

Fig. 3d    den zeitlichen Verlauf des aus Fig. 3b und c resultierenden Trägerkennlinienwerts;

Fig. 3e    den zeitlichen Verlauf des zu Fig. 3d gehörenden Speicherinhalts;

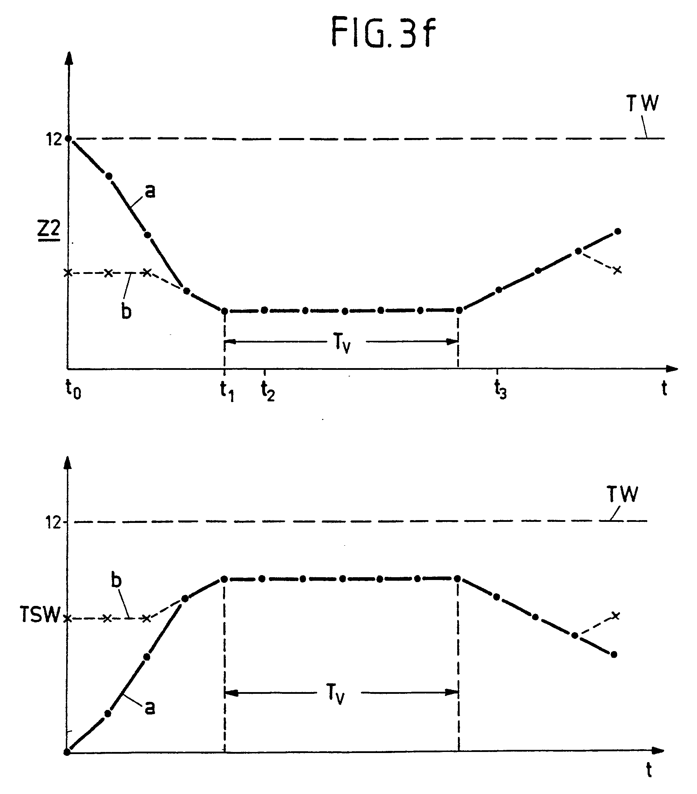

Fig. 3f    den zeitlichen Verlauf des aus Fig. 3e resultierenden Trägerabsenkungswerts;

Fig. 3g    den zeitlichen Verlauf des sich insgesamt ergebenden Trägersteuerungswerts.

In Fig: 1 ist das vereinfachte Blockschaltbild eines Senders mit Trägersteuerung nach dem Stand der Technik (CH-A-634 183) dargestellt. Ein niederfrequentes Nutzsignal $U_N$, im Allgemeinen das Programmsignal des Senders, steht an einer Eingangsklemme 1 an. Das Nutzsignal $U_N$ wird direkt auf den einen Eingang eines analogen Additionsglieds 2 gegeben. Ein Teil des Nutzsignals $U_N$ wird hinter der Eingangsklemme 1 abgezweigt, in einem Gleichrichter 7 gleichgerichtet, in einer nachgeschalteten Siebkette 8 von hörbaren Frequenzen befreit und über ein Einstellglied 9 auf den anderen Eingang des Additionsglieds 2 gegeben. Im Additionsglied 2 werden beide Eingangssignale, das Nutzsignal $U_N$ und die dynamikabhängige, langsam veränderliche Gleichspannung aus dem Einstellglied 9 überlagert und das resultierende analoge Summensignal an den Eingang eines Pulsdauermodulators 3 weitergeleitet, der das Summensignal durch Vergleich mit einer von aussen eingespeisten Sägezahnspannung in pulsdauermodulierte Impulse umsetzt.

Die pulsdauermodulierten Impulse schalten einen pulsdauermodulierten Schaltverstärker 4 ein und aus, so dass am Ausgang des Schaltverstärkers pulsdauermodulierte Hochspannungsimpulse zur Verfügung stehen, die nach vorhergehender Tiefpassfilterung zur Modulation an eine Senderendstufe 5 und von dort auf eine Antenne 6 geführt werden.

In Abhängigkeit von der Dauer der Hochspannungsimpulse ergibt sich am Eingang der Senderendstufe 5 ein Gleichspannungsanteil, der den Arbeitspunkt auf der Modulationskennlinie festlegt. Durch die Addition der dynamikabhängigen Gleichspannung und ggf. eines festen Trägerwertes TW zum Nutzsignal $U_N$ wird die Dauer der Hochspannungsimpulse dynamikabhängig beeinflusst und damit über den Modulationsarbeitspunkt auch der Trägerpegel verändert.

Die Siebkette 8, die alle hörbaren Frequenzen, d.h. alle Frequenzen oberhalb etwa 20 Hz, aus dem gleichgerichteten Nutzsignal herausfiltert, beaufschlagt die Trägersteuerung mit einer Zeitkonstanten in der Grössenordnung von 50 msec. Diese Zeitkonstante verursacht eine Verzögerung der Trägerpegeländerung sowohl bei einem plötzlichen Anstieg als auch bei einem plötzlichen Abfall der Nutzsignalamplitude. Während im zweiten Fall aus dieser Verzögerung lediglich eine verringerte Einsparung an Trägerleistung folgt, führt die Verzögerung im ersten Fall zu dynamischen Verzerrungen bei der Übertragung, da plötzliche Spitzen der Nutzsignalamplitude abgeschnitten und daher nicht mitübertragen werden.

Ein grundlegend anderes Verhalten ergibt sich für eine Schaltungsanordnung zur Durchführung des erfindungsgemässen Trägersteuerungsverfahrens, wie sie als bevorzugtes Ausführungsbeispiel im Blockschaltbild der Fig. 2 wiedergegeben ist. Eingangsklemme 1, Senderendstufe 5 und Antenne 6 haben hier dieselbe Bedeutung und Funktion wie in der bekannten Schaltungsordnung nach Fig. 1.

Unterschiede ergeben sich jedoch bereits in Art und Funktionsweise des verwendeten Schaltverstärkers. Während der pulsdauermodulierte Schaltverstärker 4 aus Fig. 1 zwar ein- und ausgeschaltet wird, jedoch wegen der stetig variierenden Impulsdauer auch weiterhin als Analogverstärker angesehen werden muss, wird in der Schaltung nach Fig. 2 ein digitaler Schaltverstärker 13 eingesetzt, wie er an sich aus der DE-A-3 044 956 bekannt ist.

Ein solcher digitaler Schaltverstärker umfasst vorzugsweise eine Vielzahl von identisch aufgebauten Schaltstufen, die im eingeschalteten Zustand jeweils dieselbe konstante Ausgangsspannung abgeben, und von denen jeweils eine solche Anzahl eingeschaltet wird, dass die Summe der Ausgangsspannungen der eingeschalteten Schaltstufen der um einen Faktor verstärkten Eingangsgrösse entspricht.

Ein digitaler Schaltverstärker der beschriebenen Art wird vorteilhafterweise durch eine digitale Eingangsgrösse angesteuert und eignet sich daher besonders zur Durchführung des erfindungsgemässen Verfahrens, bei dem die Signalverarbeitung vollständig in digitaler Form erfolgt.

In der Schaltung aus Fig. 2 gelangt das Nutzsignal $U_N$ von der Eingangsklemme 1 zunächst auf den Eingang eines Analog-Digital-Wandlers 10, wird dort mit einer weit oberhalb des Nutzfrequenzbereichs liegenden Abtastfrequenz von z. B. 100 kHz abgetastet und in eine Folge von digitalen Amplitudenwerten A umgewandelt. Die digitalen Amplitudenwerte A werden dann unter anderem in einer digitalen Rechenschaltung 20 weiterverarbeitet, die zu jedem Amplitudenwert einen geeigneten Trägerabsenkungswert Z2 berechnet und an den zweiten Eingang einer Subtraktionsschaltung 12 weitergibt, die zwischen dem Analog-Digital-Wandler 10 und dem digitalen Schaltverstärker 13 angeordnet ist.

Auf den ersten Eingang der Subtraktionsschaltung 12 gelangt jeweils ein Digitalwert (A + TW), der sich aus der Addition des digitalen Amplitudenwerts A und eines festen Trägerwerts TW ergibt. Der von aussen vorgebbare Trägerwert TW ist diejenige digitale Zahl, die bei fehlender Trägersteuerung, d.h. bei Nichtvorhandensein eines dynamikabhängigen Trägerabsenkungswert Z2, den Trägerpegel unveränderlich festlegt.

Der Trägerwert TW wird bevorzugt dadurch erzeugt, dass das um den Mittelwert 0 variierende Nutzsignal $U_N$ auf die in Fig. 2 nicht dargestellten (+)- und (-)-Eingänge des Analog-Digital-Wandlers 10 gegeben wird. Die am Ausgang des Analog-Digital-Wandlers 10 abgegebenen Digitalwerte variieren dann um die Mitte des Ausgangszahlenbereichs, die den Trägerwert TW darstellt.

Um den Trägerwert TW ändern zu können, kann zusätzlich vor dem Eingang des Analog-Digital-Wandlers 10 eine Additionsschaltung 11 vorgesehen sein, die durch Addition einer Gleichspannung zum Nutzsignal $U_N$ den Mittelwert von $U_N$ und damit auch den Trägerwert TW am Ausgang des Digital-Analog-Wandlers 10 verschiebt.

Aus der Subtraktion des Trägerabsenkungswerts Z2 von dem Trägerwert TW in der Subtraktionsschaltung 12 erhält man einen für die Trägersteuerung massgeblichen digitalen Trägersteuerungswert TSW (= TW - Z2), der zusammen mit dem digitalen Amplitudenwert A einen Steuersignalwert Z1 bildet (Z1 = A + TSW = A + TW - Z2), der für die Ansteuerung des digitalen Schaltverstärkers 13 verwendet wird.

Die digitalen Amplitudenwerte A sind zusammen mit einem festen Trägerwert TW in ihrem zeitlichen Verlauf in Fig. 3a für ein beispielhaftes Nutzsignal $U_N$ dargestellt. Der willkürlich gewählte Trägerwert TW entspricht in dieser Darstellung der Zahl 12, die um den Trägerwert TW in positiver und negativer Richtung variierenden digitalen Amplitudenwerte A sind in der Form von zeitdiskreten Punkten wiedergegeben, während die durchgezogene Kurve dem analogen Nutzsignal $U_N$ am Eingang des Analog-Digital-Wandlers 10 entspricht.

Die in Fig. 3a eingezeichnete Nutzsignalkurve erreicht zum Zeitpunkt $t_1$ ein Maximum. Bezogen auf den Trägerwert TW treten im Allgemeinen sowohl positive als auch negative Amplitudenwerte auf, von denen jeweils einer, $A_1$ und $A_2$, herausgegriffen worden ist. Da der Trägerpegel des Senders bei positiven und negativen Amplituden des Nutzsignals $U_N$ gleichermassen soweit angehoben werden muss, dass ein Abschneiden der Amplitudenspitzen vermieden wird, ist für die Trägersteuerung allein der Absolutwert der Nutzsignalamplitude von Bedeutung. Gemäss Fig. 3b werden daher alle digitalen Amplitudenwerte A aus den Digitalwerten (A + TW) in Absolutwerte /A/ umgewandelt, die dem Absolutwert der Nutzsignalamplitude entsprechen.

Der positive Amplitudenwert $A_1$ ist bei dieser Umwandlung identisch mit dem zugeordneten Absolutwert /$A_1$/, der negative Amplitudenwert $A_2$ wird dagegen in einen anderen Absolutwert /$A_2$/ transformiert. In der digitalen Rechenschaltung 20 aus Fig. 2 wird die beschriebene Umwandlung durch einen Absolutwertbildner 14 erreicht, der vorzugsweise einen oder mehrere Festwertspeicher z. B. des EPROM-Typs 2732 enthält, die von den Digitalwerten (A + TW) addressiert werden und unter der jeweiligen Adresse den zugehörigen Absolutwert /A/ eingespeichert haben. Die Umwandlung der Amplitudenwerte durch Auslesen der im Festwertspeicher eingespeicherten Absolutwerte erfolgt in Zeiten von weniger als 500 ns und erlaubt daher eine aussergewöhnliche schnelle Transformation.

Die vom Absolutwertbildner 14 abgegebenen Absolutwerte /A/ werden in der digitalen Rechenschaltung 20 auf den Eingang einer Kennlinientransformationsschaltung 15 geführt, die jedem ankommenden Absolutwert /A/ nach Massgabe einer Trägersteuerungskennlinie TK einen digitalen Trägerkennlinienwert Z3 zuordnet. Zwei bevorzugte Arten a und b der Trägersteuerungskennlinie sind in Fig. 3c dargestellt.

Die Trägersteuerungskennlinie a ist so ausgelegt, dass grossen Absolutwerten /A/ kleine Trägerkennlinienwerte Z3 zugeteilt werden und umgekehrt. Gemäss dem Beispiel erscheint am Ausgang der Kennlinientransformationsschaltung 15 der Trägerkennlinienwert Z3 = 0, wenn am Eingang der Absolutwert /A/ = 12 ansteht, bzw. der Trägerkennlinienwert Z3 = 12, wenn der eingangsseitige Absolutwert den Wert 0 besitzt.

Eine modifizierte Form b der Trägersteuerungskennlinie TK zeichnet sich demgegenüber dadurch aus, dass mittleren Absolutwerten /A/ ein gleichbleibender Trägerkennlinienwert Z3 (im Beispiel der Fig. 3c der Wert 7) zugeordnet wird, während bei kleinen Absolutwerten /A/ der Trägerkennlinienwert Z3 mit dem Absolutwert /A/ gleichsinnig abnimmt.

Für den beispielhaften zeitlichen Verlauf des Absolutwerts /A/ aus Fig. 3b ergeben sich gemäss den Arten a und b der Trägersteuerungskennlinie TK nach Fig. 3c zwei unterschiedliche Verläufe des zugehörigen Trägerkennlinienwerts Z3, die in Fig. 3d wiedergegeben sind.

Auch die Kennlinientransformationsschaltung 15 ist, wie der Absolutwertbildner 14, vorzugsweise mit programmierbaren Festwertspeichern des genannten Typs ausgeführt, in denen die verschiedenen Trägerkennlinienwerte Z3 eingespeichert sind und mittels der Absolutwerte /A/ adressiert werden.

Die resultierenden Trägerkennlinienwerte Z3 gelangen von der Kennlinientransformationsschaltung 15 auf jeweils einen Eingang eines ersten Komparators 16 und eines zweiten Komparators 18. Der erste Komparator 16 vergleicht den an dem einen Eingang anstehenden Trägerkennlinienwert Z3 mit einem digitalen Speicherinhalt Z4, der aus einem programmierbaren Zähler 17 auf den anderen Eingang gegeben wird und dem jeweiligen Zählerstand des programmierbaren Zählers 17 entspricht.

Durch den Vergleich im ersten Komparator 16 wird festgestellt, welcher der beiden eingangsseitigen Werte Z3 und Z4 der kleinere ist. Dieser kleiner Wert MIN (Z2, Z3) wird dann als digitaler Trägerabsenkungswert Z2 in der Subtraktionsschaltung 12 von der Summe aus digitalem Amplitudenwert A und festem Trägerwert TW abgezogen und gleichzeitig an den anderen Eingang des zweiten Komparators 18 weitergeleitet, wo er mit dem Trägerkennlinienwert Z3 verglichen wird.

Der Vergleich der Werte Z2 und Z3 im zweiten Komparator 18 kann zu zwei unterschiedlichen Ergebnissen führen: Ist Z2 = Z3, wird dieser Digitalwert über einen ersten Ausgang an einen Programmiereingang 23 des programmierbaren Zählers 17 weitergeleitet und dort als neuer Zählerstand übernommen. Gleichzeitig wird über einen zweiten Ausgang des zweiten Komparators 18 ein Rückstellimpuls an einen Rückstelleingang 24 eines Zeitzählers 19 abgegeben, der diesen Zeitzähler auf 0 zurückstellt.

Ist dagegen Z2 ≠ Z3, erscheint an einem dritten Ausgang des zweiten Komparators 18 ein Zählimpuls, der auf einen Zähleingang (Clockeingang) des Zeitzählers 19 gelangt und dessen Zählerstand um 1 erhöht. Der Zählerstand des Zeitzählers 19 ist ein digitales Mass für den abgelaufenen Teil einer Verzögerungszeit $T_V$, die von aussen vorgebbar das Zeitverhalten des Trägerpegels bei abklingender Nutzsignalamplitude bestimmt und vorzugsweise grösser als 20 ms ist.

Der Zählerstand des Zeitzählers 19 wird in einem Zeitkomparator 21 mit der als Digitalwert vorgegebenen Verzögerungszeit $T_V$ verglichen. Sind beide gleich, d.h. ist die Verzögerungszeit $T_V$ abgelaufen, springt der Ausgang des Zeitkomparators 21 von logisch "0" auf logisch "1", so dass ein nachgeschaltetes UND-Gatter 22 die am dritten Ausgang des zweiten Komparators 18 erscheinenden Zählimpulse ungehindert auf einen Zähleingang (Clockeingang) des programmierbaren Zählers 17 weiterleiten kann. Der Zählerstand dieses Zählers wird dadurch nach Ablauf der Verzögerungszeit $T_V$ schrittweise im Arbeitstakt der digitalen Rechenschaltung 20 erhöht, solange der Vergleich im zweiten Komparator 18 das Ergebnis Z2 ≠ Z3 liefert, d.h. solange der Speicherinhalt Z4 kleiner ist als der jeweilige Kennlinienwert Z3.

Sobald jedoch durch das schrittweise Erhöhen des Speicherinhalts Z4 oder ein Absinken des Trägerkennlinienwerts Z3 dieser Trägerkennlinienwert kleiner wird als der Speicherinhalt, erscheint Z3 als Trägerabsenkungswert Z2 am Ausgang des ersten Komparators 16, der zweite Komparator liefert daher das Ergebnis Z2 = Z3, der Zählerstand des programmierbaren Zählers 17 wird über den Programmiereingang 23 auf Z2 eingestellt und der Zeitzähler 19 zurückgestellt, so dass ein neuer Verzögerungszyklus beginnen kann.

Die aus den Komparatoren 16 und 18 und dem programmierbaren Zähler 17 als Zwischenspeicher gebildete Schleife stellt einen Speicherinhalt Z4 in der Weise zur Verfügung, dass Z4 bei fallenden Trägerkennlinienwerten Z3, d.h. bei ansteigenden digitalen Amplitudenwerten A, um ein Taktintervall verzögert, ebenfalls fällt, bei steigenden Trägerkennlinienwerten Z3, d.h. bei sinkenden digitalen Amplitudenwerten A, jedoch zunächst über die Verzögerungszeit $T_V$ auf niedrigem Niveau konstant gehalten und erst nach Ablauf von $T_V$ schrittweise erhöht wird.

Dieser Sachverhalt wird durch Fig. 3e verdeutlicht, in der das Zeitverhalten des Speicherinhalts Z4, das sich für die Trägerkennlinienwerte Z3 aus Fig. 3d ergibt, dargestellt ist. Auch hier treten für unterschiedliche Trägersteuerungskennlinien a und b unterschiedliche Wertefolgen auf, die durch die entprechenden Buchstaben a und b gekennzeichnet sind.

Durch Vergleich im ersten Komparator 16 entstehen aus den Wertefolgen der Fig. 3d und 3e (Trägerkennlinienwert Z3 bzw. Speicherinhalt Z4) für den Trägerabsenkungswert Z2 die Wertefolgen der Fig. 3f, wobei ein kleiner Trägerabsenkungswert Z2 einem hohen Trägerpegel, ein grosser Trägerabsenkungswert Z2 dagegen einem stark abgesenkten Trägerpegel entsprechen. Für einen digitalen Amplitudenwert A = 0, wie er in fig. 3a zum Zeitpunkt $t_0$ auftritt, ist daher gemäss der Trägersteuerungskennlinie a aus Fig. 3c der zugehörige Trägerabsenkungswert Z2 maximal, in dem speziellen Beispiel der Fig. 3a - 3g sogar gleich dem festen Trägerwert TW, so dass nach Subtraktion in der Subtraktionsschaltung 12 ein Steuersignalwert $Z1 = 0$ resultiert, was einem verschwindenden Trägerpegel entspricht.

Mit steigendem digitalen Amplitudenwert A zwischen den Zeitpunkten $t_0$ und $t_1$ fällt der Trägerabsenkungswert Z2 und verbleibt ab $t_1$ für die Verzögerungszeit $T_V$ auf niedrigem Niveau konstant, da alle nachfolgenden Amplitudenwerte kleiner sind als der zum Zeitpunkt $t_1$ auftretende Maximalwert, und steigt erst nach Ablauf von $T_V$ wieder schrittweise an.

Genau spiegelbildlich zum Trägerabsenkungswert Z2 verhält sich der Trägersteuerungswert TSW, der sich als Differenz zwischen dem Trägerwert TW und Z2 ergibt und in der Fig. 3g wiedergegeben ist. Das Zeitverhalten des Trägersteuerungswerts TSW ist analog zum Zeitverhalten des Trägerpegels.

Alle Teile der digitalen Rechenschaltung 20 werden vorzugsweise aus logischen Standardbausteinen aufgebaut. Für die Komparatoren 16 und 18 ebenso wie für den Zeitkomparator 21 werden einzelne oder in Serie geschaltete 4-bit-Komparatoren des Typs SN 5485 oder SN 7485 verwendet. Die Ausgabe der Digitalwerte am Ausgang des ersten Komparators 16 und am ersten Ausgang des zweiten Komparators 18 erfolgt über 6-fache D-Flip-Flops des Typ SN 54174, bei denen die an den D-Eingängen anstehenden Eingangswerte Z3 und Z4 bzw. Z2 oder Z3 je nach Vergleichsergebnis durch einen Clockimpuls auf die Q-Ausgänge übertragen werden, die mit den bezeichneten Ausgängen der Komparatoren in Verbindung stehen.

Als programmierbarer Zähler 17 und Zeitzähler 19 werden vorzugsweise synchrone 4-bit-Zähler der Typen SN 54193 oder SN 54163 verwendet und je nach bit-Zahl eines Digitalwertes einzeln oder kaskadiert eingesetzt.

Insgesamt stellt die Trägersteuerung nach der Erfindung ein in hohem Masse flexibles Steuerungsverfahren dar, das eine grosse Einsparung an Trägerleistung mit einem Minimum an dynamischen Verzerrungen kombiniert.

**Patentansprüche**

1. Verfahren zur Trägersteuerung eines amplitudenmodulierten Senders, bei dem aus einem niederfrequenten Nutzsignal ($U_N$) ein von der Dynamik des Nutzsignals ($U_N$) abhängiges Steuersignal abgeleitet und mittels eines Schaltverstärkers verstärkt und zur Modulation einer Senderendstufe (5) verwendet wird, wobei die mittlere Trägeramplitude des Senders durch das dynamikabhängige Steuersignal gesteuert wird, dadurch gekennzeichnet, dass

- die Amplitude des Nutzsignals ($U_N$) periodisch abgetastet und in digitale Amplitudenwerte (A, $A_1$, $A_2$) umgewandelt wird;
- für jeden der digitalen Amplitudenwerte (A, $A_1$,

$A_2$) nach Massgabe einer Trägersteuerungskennlinie (TK) ein digitaler Trägersteuerungswert (TSW) berechnet und zu dem jeweiligen digitalen Amplitudenwert (A, $A_1$, $A_2$) addiert wird; und
- die resultierende Summe als dynamikabhängiger, digitaler Steuersignalwert (21) mittels eines digitalen Schaltverstärkers (13) verstärkt wird, der durch den Steuersignalwert (Z1) angesteuert wird.

2. Verfahren nach Anspruch 1, dadurch gekennzeichnet, dass

- jedem der digitalen Amplitudenwerte (A, $A_1$, $A_2$) nach Massgabe der Trägersteuerungskennlinie (TK) ein digitaler Trägerkennlinienwert (Z3) zugeordnet wird;
- aus der Differenz eines festen, digitalen Trägerwerts (TW) und eines dynamikabhängigen, digitalen Trägerabsenkungswertes (Z2) der Trägersteuerungswert (TSW) bestimmt wird;
- der Trägerkennlinienwert (Z3) mit einem digitalen Speicherinhalt (Z4) verglichen wird;
- der Trägerkennlinienwert (Z3) als neuer Speicherinhalt (Z4) und als Trägerabsenkungswert (Z2) verwendet wird, wenn der Trägerkennlinienwert (Z3) kleiner ist, als der jeweilige Speicherinhalt (Z4); und
- der Speicherinhalt (Z4) für eine feste Verzögerungszeit ($T_V$) konstant gehalten, nach Ablauf der Verzögerungszeit ($T_V$) schrittweise erhöht, und als Trägerabsenkungswert (Z2) verwendet wird, wenn der Trägerkennlinienwert (Z3) grösser ist, als der jeweilige Speicherinhalt (Z4).

3. Verfahren nach Anspruch 1, dadurch gekennzeichnet, dass für die Berechnung des Trägersteuerungswerts (TSW) nur die dem Absolutwert der Nutzsignalamplitude entsprechenden digitalen Amplitudenwerte verwendet werden.

4. Verfahren nach Anspruch 2, dadurch gekennzeichnet, dass für die Zuordnung des Trägerkennlinienwerts (Z3) zu dem digitalen Amplitudenwert (A, $A_1$, $A_2$) eine Trägersteuerungskennlinie (TK) verwendet wird, die im oberen Amplitudenwertebereich eine negative Steigung aufweist.

5. Verfahren nach Anspruch 4, dadurch gekennzeichnet, dass die Trägersteuerungskennlinie (TK) für mittlere Amplitudenwerte (A, $A_1$, $A_2$) horizontal verläuft und für kleine Amplitudenwerte (A, $A_1$, $A_2$) eine positive Steigung aufweist.

6. Verfahren nach Anspruch 2, dadurch gekennzeichnet, dass die Verzögerungszeit ($T_V$) grösser als 20 ms ist.

7. Schaltungsanordnung zur Durchführung des Verfahrens nach Anspruch 1, mit einer Eingangsklemme (1) für das Nutzsignal ($U_N$), einem Schaltverstärker, und einer mit dem Ausgang des Schaltverstärkers verbundenen Senderendstufe (5), dadurch gekennzeichnet, dass an die Eingangsklemme (1) ein Analog-Digital-Wandler (10) angeschlossen ist, dass der Schaltverstärker ein digitalter Schaltverstärker (13) ist, dass zwischen dem Ausgang des Analog-Digital-Wandlers (10) und dem Eingang des digitalen Schaltverstärkers (13) eine Subtraktionsschaltung (12) und eine digitalte Rechenschaltung (20) zur Berechnung des digitalen Steuersignalwertes (Z1) derart angeordnet sind, dass der erste Eingang der Subtraktionsschaltung (12) und der Eingang der digitalen Rechenschaltung (20) mit dem Ausgang des Analog-Digital-Wandlers (10), der zweite Eingang der Subtraktionsschaltung (12) mit dem Ausgang der digitalen Rechenschaltung (20) und der Ausgang der Subtraktionsschaltung (12) mit dem Eingang des digitalen Schaltverstärkers (13) verbunden sind.

8. Schaltungsanordnung nach Anspruch 7, dadurch gekennzeichnet, dass vor dem Digital-Analog-Wandler (10) eine Additionsschaltung (11) zur Addition einer konstanten Gleichspannung zum Nutzsignal ($U_N$) angeordnet ist, und die digitale Rechenschaltung (20) für die Berechnung eines digitalen Trägerabsenkungswerts (Z2) ausgelegt ist, dessen Subtraktion vom Trägerwert (TK) den Trägersteuerungswert (TSW) ergibt.

9. Schaltungsanordnung nach Anspruch 8, dadurch gekennzeichnet, dass die digitale Rechenschaltung (20) eine Kennlinientransformationsschaltung (15), einen ersten Komparator (16), einen programmierbaren Zähler (17), einen zweiten Komparator (18), einen Zeitzähler (19), einen Zeitkomparator (21) und ein UND-Gatter (22) umfasst, wobei
- der Eingang der Kennlinientransformationsschaltung (15) mit dem Ausgang des Analog-Digital-Wandlers (10) in Verbindung steht, und der am Ausgang der Kennlinientransformationsschaltung (15) anstehende Trägerkennlinienwert (Z3) an jeweils einen Eingang des ersten (16) und des zweiten (18) Komparators weitergeleitet wird;
- der Ausgang des programmierbaren Zählers (17) mit dem anderen Eingang des ersten Komparators (16) verbunden ist;
- der am Ausgang des ersten Komparators (16) anstehende Trägerabsenkungswert (Z2) an den zweiten Eingang der Subtraktionsschaltung (12) und den anderen Eingang des zweiten Komparators (18) weitergeleitet wird;
- ein erster Ausgang des zweiten Komparators (18) bei Gleichheit der Eingangswerte den Eingangswert auf einen Programmiereingang (23) des programmierbaren Zählers (17) und ein zweiter Ausgang des zweiten Komparators (18) bei Gleichheit der Eingangswerte einen Rückstellimpuls auf einen Rückstelleingang (24) des Zeitzählers (19) gibt;
- ein dritter Ausgang des zweiten Komparators (18) bei Ungleichheit der Eingangswerte einen Zählimpuls auf den Zähleingang des Zeitzählers (19) und über einen Eingang des UND-Gatters (22) auf den Zähleingang des programmierbaren Zählers (17) gibt; und
- der Zeitkomparator (21) den Zählerstand des Zeitzählers (19) mit der voreingestellten Verzögerungszeit ($T_V$) vergleicht und bei Gleichheit der Eingangswerte einen zweiten Eingang des UND-Gatters auf "logisch 1" setzt.

10. Schaltungsanordnung nach Anspruch 9, dadurch gekennzeichnet, dass die Kennlinientransformationsschaltung (15) als programmierbarer Festwertspeicher ausgebildet ist, der durch die digitalen Amplitudenwerte (A, $A_1$, $A_2$) adressiert wird und die zugeordneten Trägerkennlinienwerte (Z3) als Speicherinhalt enthält.

**Claims**

1. Method for controlling the carrier of an amplitude-modulated transmitter, in which method a control signal dependent on the dynamic range of the useful signal ($U_N$) is derived from a useful low-frequency signal ($U_N$) and is amplified by means of a switching amplifier and used for modulating a transmitter output stage (5), the mean carrier amplitude of the transmitter being controlled by the dynamic-range-dependent control signal, characterised in that
- the amplitude of the useful signal ($U_N$) is periodically sampled and converted into digital amplitude values (A, $A_1$, $A_2$);
- for each of the digital amplitude values (A, $A_1$, $A_2$) a digital carrier-control value (TSW) is calculated as determined by carrier-control characteristic (TK) and is added to the respective digital amplitude value (A, $A_1$, $A_2$); and
- the resultant sum is amplified as dynamic-range-dependent digital control-signal value (21) by means of a digital switching amplifier (13) which is driven by the control-signal value (Z1).

2. Method according to Claim 1, characterised in that
- a digital carrier-characteristic value (Z3) is allocated to each of the digital amplitude values (A, $A_1$, $A_2$) in accordance with the determination of the carrier-control characteristic (TK);
- the carrier control value (TSW) is determined from the difference between a fixed, digital carrier value (TW) and a dynamic-range-dependent digital carrier-reduction value (Z2);
- the carrier-characteristic value (Z3) is compared with a digital memory content (Z4);
- the carrier-characteristic value (Z3) is used as new memory content (Z4) and as carrier-reduction value (Z2) when the carrier-characteristic value (Z3) is smaller than the respective memory content (Z4); and
- the memory content (Z4) is kept constant for a fixed delay time ($T_V$), is incremented step by step after the delay time ($T_V$) has elapsed, and is used as carrier-reduction value (Z2) when the carrier-characteristic value (Z3) is greater than the respective memory content (Z4).

3. Method according to Claim 1, characterised in that only the digital amplitude values corresponding to the absolute value of the amplitude of the useful signal are used for calculating the carrier-control value (TSW).

4. Method according to Claim 2, characterised in that for allocating the carrier-characteristic value (Z3) to the digital amplitude value (A, $A_1$, $A_2$) a carrier-control characteristic (TK) is used which has a negative slope in the upper range of amplitude values.

5. Method according to Claim 4, characterised in that the carrier-control characteristic (TK) extends horizontally for mean amplitude values (A, $A_1$, $A_2$) and has a positive slope for small amplitude values (A, $A_1$, $A_2$).

6. Method according to Claim 2, characterised in that the delay time ($T_V$) is greater than 20 ms.

7. Circuit arrangement for carrying out the method according to Claim 1, comprising an input terminal (1) for the useful signal ($U_N$), a switching amplifier and a transmitter output stage (5) which is connected to the output of the switching amplifier, characterised in that an analog/digital converter C 10, is connected to the input terminal (1), in that the switching amplifier is a digital switching amplifier, in that (13) between the output of the analog/digital converter (10) and the input of the digital switching amplifier (13) a subtraction circuit (12) and a digital computing circuit (20) for calculating the digital control-signal value (Z1) are arranged in such a manner that the first input of the subtraction circuit (12) and the input of the digital computing circuit (20) are connected to the output of the analog/digital converter (10), the second input of the subtraction circuit (12) is connected to the output of the digital computing circuit (20) and the output of the subtraction circuit (12) is connected to the input of the digital switching amplifier (13).

8. Circuit arrangement according to Claim 7, characterised in that in front of the digital analog (sic) converter (10) an addition circuit (11) for adding a constant direct voltage to the useful signal ($U_N$) is arranged and that the digital computing circuit (20) is designed for calculating a digital-carrier reduction value (Z2) the subtraction of which from the carrier value (TK) results in the carrier-control value (TSW).

9. Circuit arrangement according to Claim 8, characterised in that the digital computing circuit (20) comprises a characteristic-transformation circuit (15), a first comparator (16), a programmable counter (17), a second comparator (18), a time counter (19), a time comparator (21) and an AND gate (22), in which arrangement
- the input of the characteristic-transformation circuit (15) is connected to the output of the analog/digital converter (10) and the carrier-characteristic value (Z3) present at the output of the characteristic-transformation circuit (15) is passed to one input each of the first (16) and of the second (18) comparator;
- the output of the programmable counter (17) is connected to the other input of the first comparator (16);
- the carrier-reduction value (Z2) present at the output of the first comparator (16) is passed to the second input of the subtraction circuit (12) and to the other input of the second comparator (18);
- a first output of the second comparator (18) supplies with equality of the input values the input value to a programming input (23) of the programmable counter (17) and a second output of the second comparator (18) supplies with equality of the input values a reset pulse to a reset input (24) of the time counter (19);
- a third output of the second comparator (18) supplies with inequality of the input values a counting pulse to the counting input of the time counter (19) and, via an input of the AND gate (22), to the counting input of the programmable counter (17); and
- the time comparator (21) compares the count of the time counter (19) with the preset delay time ($T_V$) and with equality of the input values sets a second input of the AND gate to a "logical 1".

10. Circuit arrangement according to Claim 9, characterised in that the characteristic-transformation circuit (15) is constructed as a programmable read-only memory which is addressed by the digital amplitude values (A, $A_1$, $A_2$) and contains the associated carrier-characteristic values (Z3) as memory contents.

**Revendications**

1. Procédé de commande d'onde porteuse d'un émetteur à modulation d'amplitude, dans lequel un signal de commande dépendant de la dynamique du signal utile ($U_N$) est dérivé d'un signal utile à basse fréquence ($U_N$) et est amplifié au moyen d'un amplificateur de commutation et utilisé pour la modulation d'un étage final d'émetteur (5), l'amplitude moyenne de l'onde porteuse de l'émetteur étant commandée par le signal de commande dépendant de la dynamique, caractérisé en ce que
- l'amplitude du signal utile ($U_N$) est échantillonnée périodiquement et est convertie en valeurs d'amplitude numériques (A, $A_1$, $A_2$);
- pour chacune des valeurs d'amplitude numériques (A, $A_1$, $A_2$), une valeur de commande d'onde porteuse numérique (TSW) est calculée en fonction d'une caractéristique de commande d'onde porteuse (TK) et est additionnée à la valeur d'amplitude numérique (A, $A_1$, $A_2$) en question, et
- la somme résultante est amplifiée, à titre de valeur de signal de commande numérique dépendant de la dynamique (21), au moyen d'un amplificateur de commutation numérique (13) qui est excité par la valeur du signal de commande (Z1).

**2.** Procédé suivant la revendication 1, caractérisé en ce que

- une valeur de caractéristique d'onde porteuse numérique (Z3) est attribuée à chacune des valeurs d'amplitude numériques (A, A$_1$, A$_2$) en fonction de la caractéristique de commande d'onde porteuse (TK):
- la valeur de commande d'onde porteuse (TSW) est déterminée à partir de la différence d'une valeur d'onde porteuse numérique fixe (TW), et d'une valeur d'abaissement d'onde porteuse numérique dépendant de la dynamique (Z2);
- la valeur de caractéristique d'onde porteuse (Z3) est comparée à un contenu de mémoire numérique (Z4):
- la valeur de caractéristique d'onde porteuse (Z3) est utilisée à titre de nouveau contenu de mémoire (Z4) et de valeur d'abaissement d'onde porteuse (Z2) lorsque la valeur de caractéristique d'onde porteuse (Z3) est plus petite que le contenu de mémoire (Z4) en question, et
- le contenu de mémoire (Z4) est maintenu constant pendant un temps de retard fixe (T$_V$), est augmenté pas à pas au terme du temps de retard (T$_V$) et est utilisé en tant que valeur d'abaissement d'onde porteuse (Z2), lorsque la valeur de caractéristique d'onde porteuse (Z3) est supérieure au contenu de mémoire (Z4) en question.

**3.** Procédé suivant la revendication 1, caractérisé en ce que pour le calcul de la valeur de commande d'onde porteuse (TSW), seules les valeurs d'amplitude numériques correspondant à la valeur absolue de l'amplitude de signal utile sont utilisées.

**4.** Procédé suivant la revendication 2, caractérisé en ce qu'une caractéristique de commande d'onde porteuse (TK) qui présente une pente négative dans le domaine de valeur d'amplitude supérieur est utilisée pour l'attribution de la valeur de caractéristique d'onde porteuse (Z3) à la valeur d'amplitude numérique (A, A$_1$, A$_2$) d'une caractéristique de commande d'onde porteuse (TK).

**5.** Procédé suivant la revendication 4, caractérisé en ce que la caractéristique de commande d'onde porteuse (TK) s'étend horizontalement pour des valeurs d'amplitude moyennes (A, A$_1$, A$_2$) et présente une pente positive pour de petites valeurs d'amplitude (A, A$_1$, A$_2$).

**6.** Procédé suivant la revendication 2, caractérisé en ce que le temps de retard (T$_V$) est supérieur à 20 ms.

**7.** Montage de circuit pour l'exécution du procédé suivant la revendication 1, comportant une borne d'entrée (1) pour le signal utile (U$_N$), un amplificateur de commutation et un étage final d'émetteur (5) connecté à la sortie de l'amplificateur de commutation, caractérisé en ce qu'un convertisseur analogique-numérique (10) est connecté à la borne d'entrée (1), que l'amplificateur de commutation est un amplificateur de commutation numérique (13), qu'un circuit soustracteur (12) et un circuit de calcul numérique (20) pour le calcul de la valeur de signal de commande numérique (Z1) sont disposés entre la sortie du convertisseur analogique-numérique (10) et l'entrée de l'amplificateur de commutation numérique (13) d'une manière telle que la première entrée du circuit soustracteur (12) et l'entrée du circuit de calcul numérique (20) soient connectées à la sortie du convertisseur analogique-numérique (10), que la deuxième entrée du circuit soustracteur (12) soit connectée à la sortie du circuit de calcul numérique (20) et que la sortie du circuit soustracteur (12) soit connectée à l'entrée de l'amplificateur de commutation numérique (13).

**8.** Montage de circuit suivant la revendication 7, caractérisé en ce qu'un circuit additionneur (11) destiné à additionner une tension continue constante au signal utile (U$_N$) est disposé en amont du convertisseur numérique-analogique (10) et le circuit de calcul numérique (20) est prévu pour le calcul d'une valeur d'abaissement d'onde porteuse numérique (Z2), dont la soustraction de la valeur d'onde porteuse (TK) donne la valeur de commande d'onde porteuse (TSW).

**9.** Montage de circuit suivant la revendication 8, caractérisé en ce que le circuit de calcul numérique (20) comporte un circuit de transformation de caractéristique (15), un premier comparateur (16), un compteur programmable (17), un second comparateur (18), un compteur de temps (19), un comparateur de temps (21) et un circuit-porte ET (22), où

- l'entrée du circuit de transformation de caractéristique (15) est connectée à la sortie du convertisseur analogique-numérique (10) et la valeur de caractéristique d'onde porteuse (Z3) présente sur la sortie du circuit de transformation de caractéristique (15) est transmise chaque fois à une entrée du premier comparateur (16) et du second comparateur (18);
- la sortie du compteur programmable (17) est connectée à l'autre entrée du premier comparateur (16);
- la valeur d'abaissement d'onde porteuse (Z2) présente sur la sortie du premier comparateur (16) est transmise à la deuxième entrée du circuit soustracteur (12) et à l'autre entrée du second comparateur (18);
- une première sortie du second comparateur (18) donne, en cas d'égalité des valeurs d'entrée, la valeur d'entrée sur une entrée de programmation (23) du compteur programmable (17) et une seconde sortie du second comparateur (18) donne, en cas d'égalité des valeurs d'entrée, une impulsion de retour à l'état initial sur une entrée de retour à l'état initial (24) du compteur de temps (19);
- une troisième sortie du second comparateur (18) donne, en cas d'inégalité des valeurs d'entrée, une impulsion de comptage sur l'entrée de comptage du compteur de temps (19) et, par l'intermédiaire d'une entrée du circuit-porte ET, (22), sur l'entrée de comptage du compteur programmable (17), et
- le comparateur de temps (21) compare l'état de comptage du compteur de temps (19) avec le temps de retard préréglé ($T_V$) et, en cas d'égalité des valeurs d'entrée, positionne une seconde entrée du circuit-porte ET à la valeur logique "1".

10. Montage de circuit suivant la revendication 9, caractérisé en ce que le circuit de transformation de caractéristique (15) a la forme d'une mémoire fixe programmable qui est adressée par les valeurs d'amplitude numériques (A, $A_1$, $A_2$) et qui contient, à titre de contenu de mémoire, les valeurs de caractéristique d'onde porteuse (Z3) associées.

FIG.1

FIG.2

1

FIG.3a

FIG.3b

FIG.3c

FIG.3d

FIG.3e

# FIG.3f

# FIG.3g